# EUROPEAN PATENT APPLICATION

(11) **EP 1 139 704 A1**
(43) Date of publication of application: **04.10.2001**
(21) Application number: 00915370.1
(22) Date of filing: 06.04.2000
(51) Int. Cl.: H05K 3/00, H05K 3/46

(54) **COPPER-CLAD PLATE AND LASER MACHINING FOR COPPER-CLAD PLATE**

(30) Priority: 24.08.1999 JP 23733599
(71) Applicant: Mitsui Mining & Smelting Co., Ltd., Tokyo 141-8584 (JP)
(72) Inventor: Kuwako, Fujio Mitsui Mining & Smelting Co., Ltd., AAgeo-shi, Saitama 362-0013 (JP); Ishino, Tomohiro Mitsui Mining & Smelting Co., Ltd, Ageo-shi, Saitama 362-0013 (JP)
(74) Representative: Allard, Susan Joyce
(86) International application number: JP0002224
(87) International publication number: WO0115500

(57) **Abstract**

The invention provides a copper-clad laminate for undergoing laser processing, in which laminate a through hole or a via hole portion is formed to be converted to a plated through hole or a via hole which ensures interlayer contact between an outer copper foil and a copper foil circuit layer. In order to attain the object, the laser beam reflectance of the outer copper foil surface of the employed copper-clad laminate is adjusted to 86% or less or the lightness (L value) is adjusted to 22 or less by forming microparticles of copper oxide or copper on the outer copper foil.

## Description

### Technical Field

The present invention relates to a copper-clad laminate and to a laser processing method employing the copper-clad laminate. More particularly, the present invention relates to a copper-clad laminate for undergoing laser processing, through which holes communicating through a copper foil portion and a resin portion are formed.

### Background Art

In recent years, electric and electronic apparatus such as computer hardware, computer-related apparatus, video-related apparatus, and mobile communications apparatus have been remarkably down-sized. According to the trend, elements, such as electronic elements and printed wiring boards, composing the apparatus must also be down-sized.

Thus, there are increasing and keen demands for a finer pitch between conductive lines in a printed wiring board, a smaller diameter of through holes and a variety of types of via holes, and smaller thickness of a wiring board. Among them, in printed wiring boards, small holes for providing through holes and a variety of types of via holes have conventionally been formed through drilling, to thereby form holes simultaneously in a plurality of stacked printed wiring boards. When a plurality of drills are employed, this drilling process advantageously enhances productivity of printed wiring boards, as expected.

Through typical drilling, small holes having a diameter of 0.3-0.4 mm are formed. Furthermore, small holes having a diameter of approximately 0.15-0.25 mm can be formed due to recent progress in technology.

In addition, drilling for providing holes having a diameter of 0.1-0.05 mm by employing a super-hard drill is now under investigation. However, there still remain many technical problems to be solved; e.g., the service life of a drill and resistance to drilling of a material for a printed wiring board.

Regardless of these problems, a recent trend for downsizing of electric and electronic apparatus is overwhelming in the actual market, which cannot await the development of drilling technology. In order to satisfy the demand, laser processing has been employed for providing small holes having a diameter of 0.1 mm or less.

When small holes are formed in a printed wiring board through laser processing, there are two possible modes. One mode is irradiation of a resin substrate with a laser beam (mode (1)), and the other mode is irradiation of a copper foil surface on which a circuit is formed with a laser beam (mode (2)). In the latter mode, laser processing is more difficult, since a copper foil having a shiny side reflects a laser beam.

In reality, laser processing of the latter case can hardly be attained. When a copper foil reflects a laser beam, the efficiency of initial absorption of the laser beam decreases, to thereby lower the speed of formation of holes and production efficiency of printed wiring boards. Therefore, when laser hole formation is carried out in the aforementioned mode (2), hole-forming portions of the outer copper foil must be eliminated in advance by etching.

When etching is performed, an etching resist is applied to the copper surface. However, it is considerably difficult to precisely determine positions for forming a hole as designed, due to poor resolution of the etching resist. Therefore, position matching between a via hole formed through laser processing and land pads serving as contact portions of an inner circuit formed from a copper foil fails. Thus, the land pads in an inner circuit formed from a copper clad laminate are designed in a larger dimension, in consideration of dimensional error. This is disadvantageous for miniaturizing an inner circuit formed from a copper clad laminate.

In view of the foregoing, there is demand for developing a copper-clad laminate which enables a copper foil and a resin layer to undergo reliable and simultaneous laser processing without carrying out etching of the copper foil.

### Brief Description of the Drawings

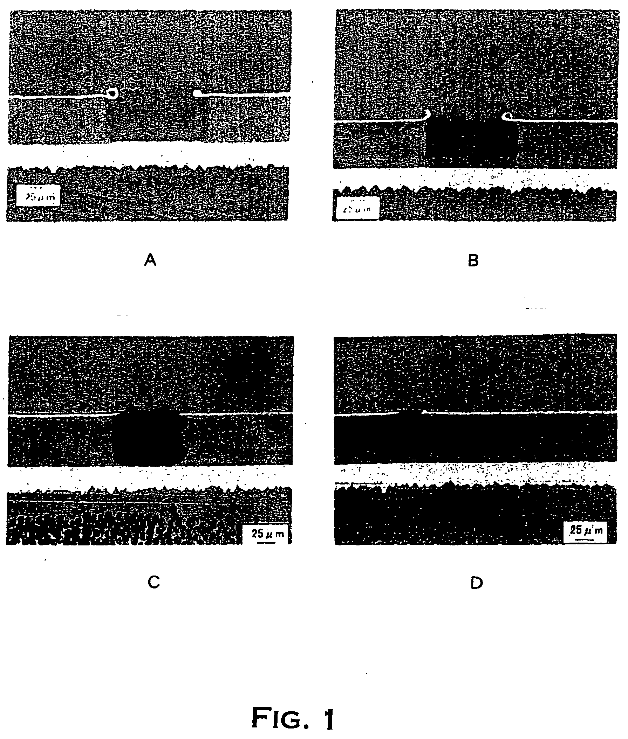

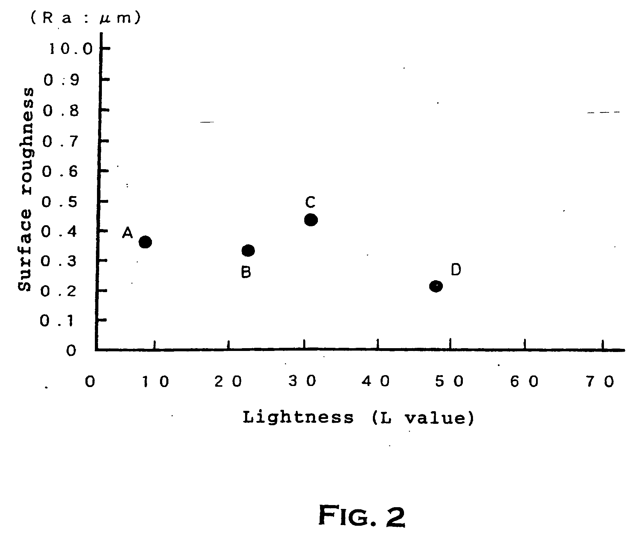

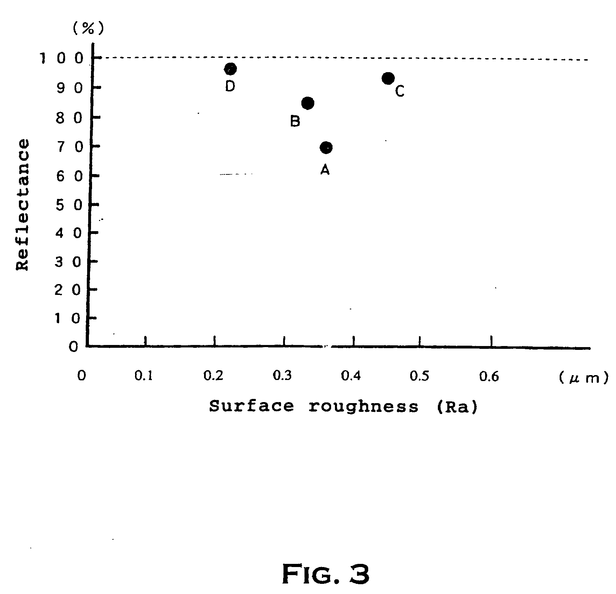

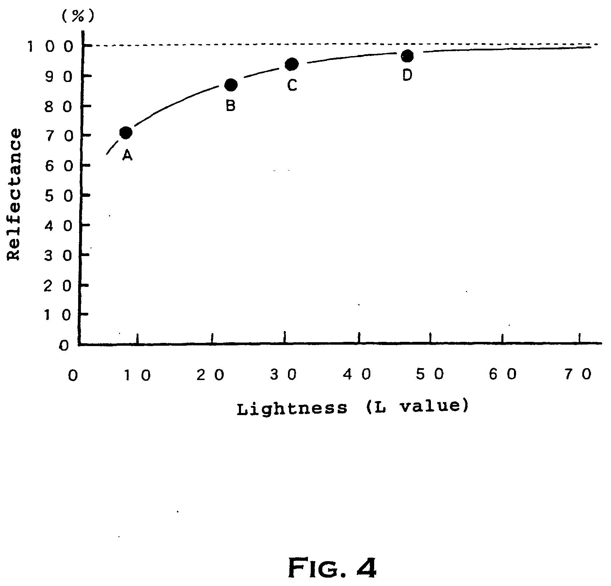

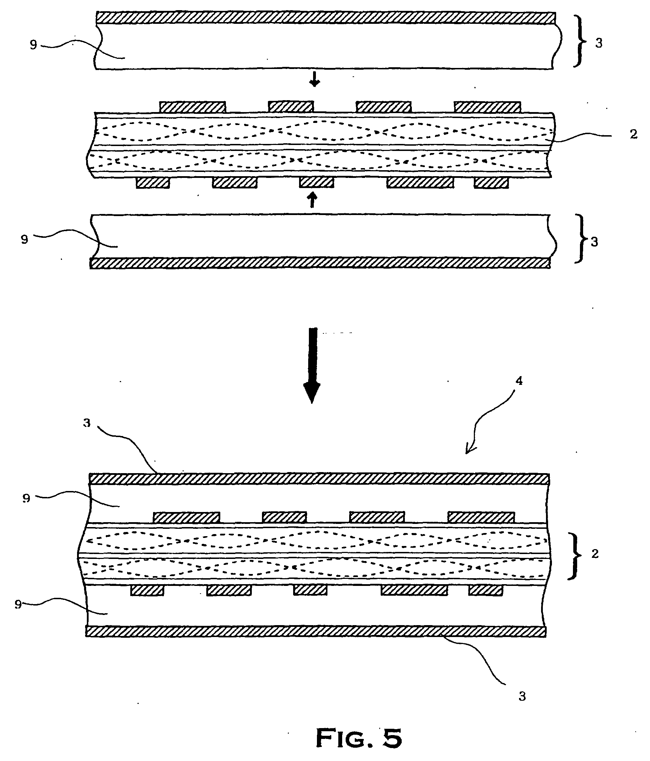

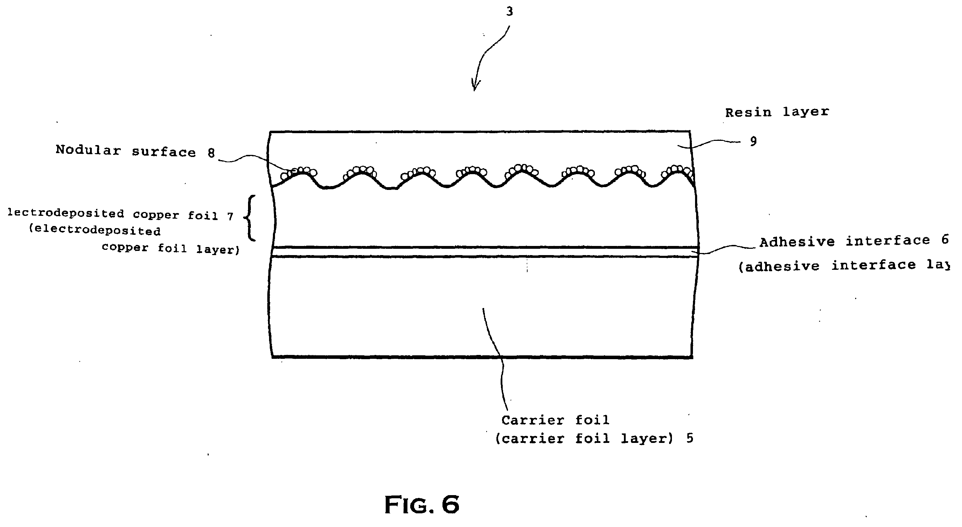

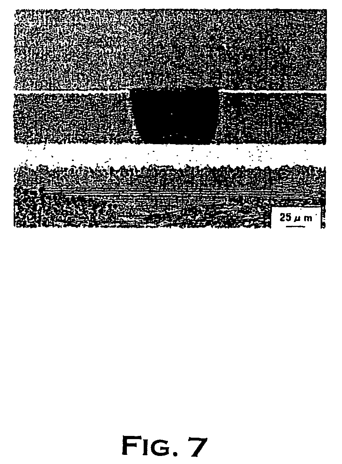

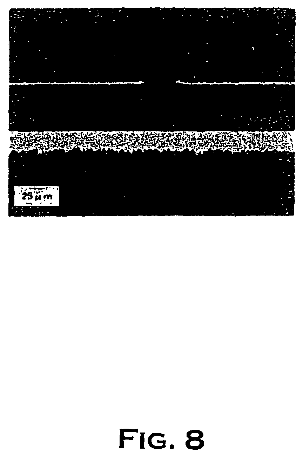

Fig. 1 shows photographs depicting observed crosssections of a via hole formed through laser processing. Fig. 2 is a graph showing the relationship between lightness and surface roughness of surfaces of copper foils. Fig. 3 is a graph showing the relationship between reflectance and surface roughness of surfaces of copper foils. Fig. 4 is a graph showing the relationship between reflectance and lightness of surfaces of copper foils. Fig. 5 shows a schematic cross-sectional view of a copper-clad laminate. Fig. 6 is a schematic cross-sectional view of an electrodeposited copper foil with carrier. Each of Figs. 7 and 8 shows a cross-sectional view of a via hole formed through laser processing.

### Summary of the Invention

The present inventors have conducted earnest studies on the relationship between reflection of a laser beam on the surface of a copper foil and surface conditions of the foil, and have clarified properties of a copper-clad laminate suitable for laser processing. The present invention has been accomplished on the basis of this finding. The term "copper-clad laminate" refers to a laminate which is a precursor for providing a printed wiring board, serving as a final product, and which is prepared by press-forming a copper foil and a substrate.

The present inventors have found that laser beam processing of a copper foil can readily be performed regardless of the processing conditions, if the copper foil satisfies certain surface conditions. Accordingly, in claim 1 of the present invention, there is provided a copper-clad laminate for undergoing laser processing, in which laminate a through hole or a via hole portion is formed to be converted to a plated through hole or a via hole which ensures interlayer connection between an outer copper foil and a copper foil circuit layer, wherein the outer copper foil surface of the copper-clad laminate has a laser beam reflectance of 86% or less.

The present inventors have prepared copper-clad laminates in which the outer copper foils differ in surface conditions, so as to determine the optimum parameters for laser hole formation, by comparing the surface conditions of the copper foil in terms of three parameters; i.e., reflectance, lightness, and surface roughness.

Four types of outer copper foils of copper-clad laminates were evaluated. The. reflectance, lightness, surface roughness, and laser hole formability of each foil are shown in Table 1. Relationships between parameters have been investigated on the basis of the parameters. Although the reflectance herein refers to the reflectance of a CO₂ laser beam having a wavelength of 9.3 µm, the reflectance of other laser beams of other sources having different wavelengths is approximately equal to the above reflectance.

**[Table 1]**

| Sample No. | Reflectance (%) | Lightness | Surface roughness /Ra (µm) | Laser hole formability |
|---|---|---|---|---|
| A | 71 | 7.99 | 0.368 | good |
| B | 86 | 22.00 | 0.331 | fair |
| C | 93 | 30.01 | 0.443 | poor |
| D | 95 | 47.18 | 0.222 | |

The laser hole formability shown in Fig. 1 was evaluated through observation of the shape of a cross-section of a via hole portion formed by laser processing as shown in Fig. 1. The photographs shown in Fig. 1 correspond to cross-sections of via hole portions formed in samples A to D. The conditions employed for laser processing were: apparatus: CO₂ laser; frequency: 2000 Hz; mask: 5.0 mm-diameter; pulse width: 1 shot, 20 µs, 18.3 mJ; and offset: 0.8. Cross-sectional shape is evaluated as "good" for sample A; "fair" for sample B; and poor for samples C and D.

The relationships between the parameters were investigated on the basis of the data shown in Table 1. In Fig. 2, lightness and surface roughness are plotted. As is clear from Fig. 2, no clear relationship between lightness and surface roughness can be obtained. Although lightness and surface roughness do not correlate, lightness and laser hole formability correlate in consideration of evaluation of hole formability.

In Fig. 3, reflectance and surface roughness are plotted. As is clear from Fig. 3, no clear relationship between reflectance and surface roughness can be obtained. Although reflectance and surface roughness do not correlate, reflectance and laser hole formability do correlate, in consideration of evaluation of hole formability.

In Fig. 4, reflectance and lightness are plotted. As is clear from Fig. 4, a logarithmic relationship between reflectance and lightness is found. The higher the lightness, the closer the reflectance approaches 100%. Thus, the present inventors have conducted a number of experiments employing an increased number of samples, and have found that when a copper foil of a copper-clad laminate has a surface having a reflectance of 86% or less and a lightness of 25 or less; i.e., lightness falling within a region defined by the broken line and specified with a broken line in Fig.4 satisfactory laser hole formability can be attained.

Thus, claim 1 is directed to the case in which a copper-clad laminate for undergoing laser processing has a reflectance of 86% or less. As is clear from the above description, the lightness of the outer copper foil of a copper-clad laminate is also a suitable index for monitoring laser hole formability.

Accordingly, in claim 2 of the present invention, there is provided a copper-clad laminate according to claim 1 for undergoing laser processing, in which laminate a through hole or a via hole portion is formed to be converted to a plated through hole or a via hole which ensures interlayer contact between an outer copper foil and a copper foil circuit layer, wherein the outer copper foil surface of the copper-clad laminate has a lightness (L value) of 25 or less.

As used herein, the term "L value" refers to an index of lightness employed in the Munsell system, which is widely employed for evaluating lightness and chromaticity of color. The L value was measured by means of a color-difference meter.

In claim 3, there is disclosed a copper-clad laminate 1 for undergoing laser processing, wherein the outer copper foil surface of a printed wiring board that is to be irradiated with a laser beam is coarsened by formation of microparticles of copper oxide or copper. The surface of the copper foil is coarsened by formation of microparticles of copper oxide or copper on the surface of the outer copper foil in order to attain the reflectance and lightness as described in claim 1 or 2.

In general, when the aforementioned reflectance and lightness of the surface of the outer copper foil are attained by formation of the microparticles of copper oxide or copper, the surface of the foil assumes dark brown or black. Such a surface has been proven to have an enhanced laser beam absorption at an initial stage of irradiation. If the initial absorption increases, uniform and flat holes are formed at an initial stage of laser beam irradiation. In addition, when the technical concept involved in claim 3; i.e., employment of an electrodeposited copper foil with carrier, is combined with formation of microparticles, more preferred laser hole formability can be attained.

No particular limitation is imposed on the method for forming microparticles of copper oxide or copper, so long as the microparticles are deposited on the copper foil. Examples of the microparticles include copper oxide particles formed through the black oxide treatment method and copper particles obtained by reducing copper oxide with zinc or similar substances through reduction-black oxide treatment.

However, the reflectance and/or lightness as described in claim 1 or 2 must be satisfied. Since the relationship between reflectance and lightness as shown in Fig. 4 is considered to be established, satisfaction of one condition may also satisfy the other condition. The form of the microparticles of copper oxide or copper is not limited to spherical, and any form such as needles and dendrites may be employed, since the form of the microparticles of copper oxide or copper is considered to vary in accordance with the method for formation thereof.

In claim 4, there is provided a copper-clad laminate according to any one of claims 1 to 3 for undergoing laser processing, wherein an electrodeposited copper foil with carrier is employed as the outer copper foil and is formed by forming an adhesive interface layer comprising an organic agent on the carrier; depositing the electrodeposited copper foil layer on the adhesive interface layer; and forming a resin layer on the surface of the electrodeposited copper foil layer.

In a copper-clad laminate for undergoing laser processing initiated from the outer copper foil surface to provide a circuit, the outer copper foil preferably has as small a thickness as possible, in view of productivity. Thus, preferably used is an electrodeposited copper foil with carrier which enables a copper foil having a thickness of approximately 3 µm to be processed into a copper-clad laminate at high yield.

The electrodeposited copper foil with carrier is a type of copper foil, in which a carrier foil and a copper foil are bonded together. The copper foil with carrier protects and reinforces a ultrathin copper foil and prevents generation of wrinkles in the foil until the production steps of copper-clad laminates are completed, thereby remarkably improving the production yield of copper-clad laminates. In general, the electrodeposited copper foil with carrier is categorized into two types; one is a peelable type foil and the other is an etchable type foil. When the peelable type foil is employed, a carrier foil is released after completion of production of copper-clad laminates, thereby forming a circuit, whereas when the etchable type foil is employed, a carrier foil is removed by etching to form a circuit.

When a carrier foil of the etchable type foil is etched, a specific etching apparatus is required, thereby elevating production cost. In contrast, the peelable type foil can be used by peeling a carrier foil and is more advantageous than the etchable type foil. Particularly, among copper foils with peelable carrier, preferably used is a copper foil with carrier which is formed by forming an adhesive interface layer comprising an organic agent on the carrier; depositing the electrodeposited copper foil on the adhesive interface layer; and forming a resin layer on the surface of the electrodeposited copper foil layer.

The electrodeposited copper foil with carrier in which an adhesive interface between a carrier foil and a copper foil is formed from an organic material has a moderate peel strength at the interface. Thus, peeling is readily and stably carried out by an manual operation and the copper foil with carrier ensures a minimum strength required during production of copper-clad laminates.

The resin layer which is formed on the electrodeposited copper foil layer serves as an adhesion face bonded to a substrate during press-forming into a copper-clad laminate. The resin layer is employed to reduce "angulation" in a surface of a prepreg which is laminated to form a substrate and to attain favorable adhesion to the prepreg. A prepreg typically comprises glass fiber impregnated with a resin such as an epoxy resin or a melamine resin, the resin being semicured. The prepreg and a copper foil are press-formed and completely cured, to thereby prepare a copper-clad laminate.

The completely cured prepreg is a kind of fiber-reinforced plastics (FRP). Thus, glass cloth therein provides angulation to the surface of the substrate. The resin layer plays a role in reducing angulation provided from the glass cloth. Thus, when a surface of a copper-clad laminate is rendered to be more flat, the substrate is subjected to uniform irradiation with a laser beam during laser processing, and holes can be formed with higher precision.

When a resin layer having a thickness of 20 µm or more is formed on the outer copper foil, a prepreg to be formed between the outer copper foil and a core material during production of multilayer printed wiring boards may be omitted. Thus, a glass-cloth-free insulating layer is formed between an outer copper foil and a core material, thereby attaining laser processing with high precision. In other words, glass cloth, having processability lower than that of resin and providing an unfavorable shape of the inner wall of a hole formed during laser hole formation, is omitted.

Furthermore, in claim 5, there is provided a copper-clad laminate according to any one of claims 1 to 4 for undergoing laser processing, wherein a resin layer for enhancing efficiency of laser beam absorption is formed on the surface of the outer copper foil to be irradiated with a laser beam.

The resin layer for enhancing efficiency of laser beam absorption is formed in order to further enhance the aforementioned effects of the present invention. Thermoplastic resins exhibiting high absorption in an infrared band including the wavelength of a laser beam are preferably employed as the resin layer for enhancing efficiency of laser beam absorption. Specific examples include polyethylene terephthalate (PET) and polyethylene.

In claim 6, there is provided a laser processing method for a copper-clad laminate employing a copper-clad laminate as recited in any one of claims 1 to 5, wherein a through hole or a via hole portion to be converted to a plated through hole or a via hole is formed by a laser beam.

The laser processing method employs the aforementioned copper-clad laminates. No particular limitation is imposed on the types of lasers, and a variety of lasers such as an Ar laser and a CO₂ laser may be used. Laser radiation conditions may be appropriately selected in consideration of characteristics of the substrate, such as material and thickness.

### Examples

Modes for carrying out the invention will next be described. The simplest and most comprehensive example of methods for producing a copper-clad laminate according to the present invention and evaluation of laser processing characteristics are described.

In order to produce a copper-clad laminate 1 according to the present invention, a double-sided printed wiring board 2 in which circuits had been formed by etching in advance was provided. An electrodeposited copper foil with carrier 3 was placed on each side of the double-sided printed wiring board 2, and the three elements were hot-pressed, thereby forming a copper-clad laminate 4 as shown in the schematic cross-sectional view of Fig. 5

As is clear from the schematic cross-sectional view of Fig. 6, the employed electrodeposited copper foil with carrier 3 comprises a carrier foil 5 having a thickness of 18 µm; an adhesive interface 6 formed of carboxybenzotriazole coating film; an electrodeposited copper foil 7 having a thickness of 5 µm and formed through electrodeposition on the adhesive interface 6; and an epoxy resin layer 9 having a thickness of 70 µm and formed on a nodular surface 8 of the electrodeposited copper foil 7. These elements were hot-pressed, and then the carrier foil 5 was released to thereby prepare a customary copper-clad laminate 4, in which an outer copper foil is formed of the electrodeposited copper foil 7 having a thickness of 5 µm and provided from the electrodeposited copper foil with carrier 3.

Subsequently, the electrodeposited copper foil 7 serving as an outer layer of the copper-clad laminate 4 is subjected to black oxide treatment, thereby depositing copper oxide microparticles thereon and assuming blackish brown. The black oxide treatment was carried out in a solution containing sodium chlorite (25 g/L), sodium hydride (20 g/L), and an alkylate ester (6 g/L) at a solution temperature of 67°C for four minutes.

The thus-treated outer copper foil 7 of the copper-clad laminate 4 had a surface exhibiting a reflectance of 75% and a lightness (L value) of 20. Then, a via hole was formed in the copper-clad laminate by means of a CO₂ laser. Specifically, a predetermined portion of the outer copper foil 7 was irradiated with a CO₂ laser beam, to thereby form a hole penetrating the outer copper foil 7 and the cured resin layer 9 thereunder. Thus, a via hole 11 reaching an inner copper foil 10 was obtained. The laser radiation conditions are identical to those described above, and description thereof is omitted. The observed cross-section of the via hole 11 is shown in Fig. 7. As is clear from Fig. 7, the formed via hole had an approximately hollow cylindrical form, and the inner wall of the via hole was considerably flat and smooth.

In addition, the present inventors similarly formed a via hole by laser, as a comparative example, except that the aforementioned black oxide treatment was omitted and the surface of the outer copper foil was shiny. The observation is shown in Fig. 8. As is clear from Fig. 8, the formed hole was unsatisfactory and did not reach the inner copper foil 10. This clearly indicates that the copper-clad laminate 1 according to the present invention has remarkably excellent laser hole formability.

### Effects of the Invention

By employing the copper-clad laminate according to the present invention, laser processing for forming a favorable through hole or via hole can be attained without rigorous control of laser processing conditions. In addition, laser processing can be completed within a short period of time, thereby remarkably enhancing production yield. Thus, by employing the copper-clad laminate according to the present invention, finer circuit design can be realized, thereby enhancing a component mounting density and greatly enhancing reliability of interlayer connection in a multilayer printed wiring board.

## Claims

1. A copper-clad laminate for undergoing laser processing, in which laminate a through hole or a via hole portion is formed, by laser processing, to be converted to a plated through hole or a via hole which ensures interlayer contact between an outer copper foil and a copper foil circuit layer, wherein an outer copper foil surface of the copper-clad laminate has a reflectance of 86% or less.

2. A copper-clad laminate for undergoing laser processing according to claim 1, in which laminate a through hole or a via hole portion is formed, by laser processing, to be converted to a plated through hole or a via hole which ensures interlayer contact between an outer copper foil and a copper foil circuit layer, wherein the outer copper foil surface of the copper-clad laminate has a lightness (L value) of 25 or less.

3. A copper-clad laminate for undergoing laser processing according to claim 1 or 2, in which laminate a through hole or a via hole portion is formed, by laser processing, to be converted to a plated through hole or a via hole which ensures interlayer contact between an outer copper foil and a copper foil circuit layer, wherein an outer copper foil surface of a printed wiring board that is to be irradiated with a laser beam is coarsened by formation of microparticles of copper oxide or copper.

4. A copper-clad laminate for undergoing laser processing according to any one of claims 1 to 3, wherein an electrodeposited copper foil with carrier is employed as the outer copper foil and is formed by forming an adhesive interface layer comprising an organic agent on the carrier; depositing the electrodeposited copper foil layer on the adhesive interface layer; and forming a resin layer on the surface of the electrodeposited copper foil layer.

5. A copper-clad laminate for undergoing laser processing according to any one of claims 1 to 4, wherein a resin layer for enhancing efficiency of laser beam absorption is formed on the surface of the outer copper foil.

6. A laser processing method for a copper-clad laminate employing a copper-clad laminate as recited in any one of claims 1 to 5, wherein a through hole or a via hole portion to be converted to a plated through hole or a via hole is formed by a laser beam.
